# EUROPEAN PATENT SPECIFICATION

(11) **EP 2 262 001 B1**
(45) Date of publication and mention of the grant of the patent: **25.07.2018**
(21) Application number: 09722647.6
(22) Date of filing: 19.03.2009
(51) Int. Cl.: H01L 31/048, C08K 3/22, C08K 5/524, C08L 23/08, B32B 17/10, C08J 5/18

(54) **PAIR OF SEALING FILMS AND SOLAR BATTERY USING THE PAIR OF SEALING FILMS**
DICHTFILMPAAR UND DAS DICHTFILMPAAR VERWENDENDE SOLARBATTERIE
PAIRE DE FILMS D'ÉTANCHÉITÉ ET BATTERIE SOLAIRE L'UTILISANT

(30) Priority: 21.03.2008 JP 2008074128
(43) Date of publication of application: 15.12.2010
(73) Proprietor: Kyocera Corporation, Kyoto-shi Kyoto 612-8501 (JP)
(72) Inventor: KATAOKA, Hisataka, Yokohama-shi Kanagawa 244-8510 (JP); ASANO, Katsumi, Ise-shi Mie 516-0003 (JP); ITO, Naoya, Ise-shi Mie 516-0003 (JP)
(74) Representative: Oxley, Robin John George
(86) International application number: PCT/JP2009/055488
(87) International publication number: WO 2009/116638

(56) References cited:
- WO-A1-2008/056730
- JP-A- 8 316 508
- JP-A- 9 069 646
- JP-A- 11 103 087
- JP-A- 11 177 110
- JP-A- 60 181 147
- JP-A- H03 137 145
- JP-A- 2000 315 810
- JP-A- 2005 029 588
- JP-A- 2007 329 240
- JP-A- 2008 041 800
- JP-A- 2008 041 800
- JP-A- 2008 053 377
- JP-A- 2008 053 377
- JP-A- 2008 115 344
- JP-A- 2008 118 073
- JP-B- 49 013 616
- US-A- 6 093 757

## Description

### Field of the Invention

The present invention relates to a pair of sealing films comprising ethylene-vinyl acetate copolymer as a main component, and a solar battery comprising the pair of sealing films.

### Background Art

In recent years, a solar battery, that is, a device that directly converts solar energy into electrical energy has become widely used. Such solar batteries provide an effective use of natural resources and prevent environmental pollution. Further development of solar batteries is in progress.

Generally speaking, a solar battery includes a light-receipt side transparent protection member, and a back side protection member (back cover). A plurality of solar cells such as silicone power generating elements are provided between the light-receipt side and back side protection members by way of a first sealing film provided on the light receipt side, and a second sealing film provided on the back side of the solar battery.

Ethylene-vinyl acetate copolymer (EVA) is preferably used as light-receipt side and back side sealing films, because the copolymer is low-priced and has excellent transparency and adhesion property (Patent literature 1).

When a solar battery is used outdoors in a circumstance including a high temperature, high humidity and wind and rain exposure for a long time, it is possible that moisture or water will penetrate the solar battery. For example, a solar battery comprises EVA, vinyl acetate is included as the structural component. It was found that vinyl acetate is liable to gradually hydrolyze to acetic acid over time, by moisture/water penetration to the solar battery at a high temperature. When the acetic acid contacts a conductor or electrode in the solar battery, the rust generation/corrosion is accelerated.

Patent literature 2 discloses an EVA film as a transparent film to be used as a sealing film for a solar battery. The EVA film comprises an acid acceptor having a mean particle diameter of 5 µm or less in an amount of 0.5 wt.% or less. The EVA film comprising the acid acceptor prevents the formation of acetic acid, and the longevity of the solar battery comprising the EVA will be improved. WO 2008/056730 (an Article 54(3) EPC citation) discloses a solar battery comprising sealing films.

Patent Literature 1: Japanese Patent No. 3473605
Patent Literature 2: JP-A 2005-29588

### Disclosure of the Invention

### Problems to be Solved by the Invention

For restricting rust generation on a conductor or electrode in a solar battery, and hence improving the durability of the solar battery, as discussed above, it is effective to add an acid acceptor to a first or a second sealing film. However, the addition of an inorganic powder such as the acid acceptor sometimes decreases the transparency of the sealing film. That is to say, it is possible to decrease the power generation performance of a solar battery, when a large amount of an acid acceptor is simply added to the sealing film.

It is therefore an object of the present invention to provide a pair of sealing films preferably used for a solar battery, or a solar battery having an improved durability by restricting rust generation on a conductor or an electrode in the solar battery.

### Means for Solving the Problems

The object of the present invention is solved by a pair of sealing films for sealing a seal target member configured to be interposed between the sealing films. The pair of sealing films are characterized by comprising ethylene-vinyl acetate copolymer, the first sealing film comprising magnesium hydroxide in an amount of 0.2 parts by weight or less based on 100 parts by weight of the ethylene-vinyl acetate copolymer, and the second sealing film comprising magnesium hydroxide in an amount of 0.01 parts by weight or more based on 100 parts by weight of the ethylene-vinyl acetate copolymer, wherein the second sealing film comprises a lubricant.

The object of the present invention is solved by a solar battery comprising a light-receipt side transparent protection member, a first sealing film comprising ethylene-vinyl acetate copolymer which covers the light-receipt side transparent protection member, a back-side protection member, and a second sealing film comprising ethylene-vinyl acetate copolymer which covers the back-side protection member, and solar cells provided between the first and the second sealing films. In the solar battery of the invention, the first sealing film comprises 0.2 parts by weight or less of magnesium hydroxide based on 100 parts by weight of the ethylene-vinyl acetate copolymer; and the second sealing film comprising 0.01 parts by weight or more of magnesium hydroxide based on 100 parts by weight of the ethylene-vinyl acetate copolymer wherein the second sealing film comprises a lubricant.

### Effect of the Invention

In the pair of sealing film or the solar battery of the present invention, it is possible to prevent rust generation on a conductor or an electrode provided in a solar battery without decreasing electrical power generation properties even by the addition of an acid acceptor to the sealing films. The solar battery of the present invention exhibits excellent power generation properties over a long time period, and has improved durability.

### Brief Explanation of the Drawings

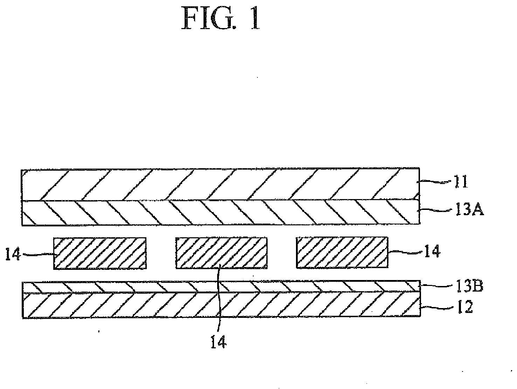

[Fig. 1] Fig. 1 is a cross section of a solar battery.

### Explanation of Reference numerals

- 11: Light-receipt side transparent protection member
- 12: Back side protection member
- 13A: First sealing film (Light-receipt side sealing film)
- 13B: Second sealing film (Back side sealing film)
- 14: Solar cell

### Best mode for carrying out the invention

In the first place, a solar battery as an embodiment of the present invention is configured by comprising a light-receipt side transparent protection member 11 and a back side protection member 12, and a pair of sealing films provided between the protection members 11 and 12, as shown in Fig. 1. The pair of sealing films comprises a first sealing film 13A to be provided at a light-receipt side of the solar battery, and a second sealing film 13B to be provided at a back side thereof. A plurality of solar cells 14 are sealed by the pair of sealing films by being interposed therebetween. In the embodiment of the invention, the solar battery comprises a member to be sealed such as solar cells between the pair of sealing films.

In the present invention, a side of a solar cell from which the light is irradiated is referred to as "light-receipt side", and a reversed side, with respect to the light-receipt side, of solar cell is referred to as "bask side".

Both the first and the second sealing films comprise ethylene-vinyl acetate copolymer. Therefore, the sealing films of the present have an excellent adhesion property with respect to the light-receipt side and the back side protection members. The sealing films of the invention are economically obtained, and restricts water penetration into an inner part of the solar battery.

The first and the second sealing films comprise magnesium hydroxide as the acid acceptor. Each of the first and the second sealing films contains magnesium hydroxide in an optimized content. Specifically, the first sealing film to be provided on the light-receipt side comprises 0.2 parts by weight or less of magnesium hydroxide based on 100 parts by weight of the ethylene-vinyl acetate copolymer. The second sealing film to be provided on the back side comprises 0.01 part by weight or more of magnesium hydroxide based on 100 parts by weight of the ethylene-vinyl acetate copolymer. Based on the above-mentioned contents of the magnesium hydroxide, the first sealing film can maintain the transparency, without decreasing the power generation property. Hence, it is possible to provide a solar battery wherein the rust generation on a conductor or an electrode in the cell is highly restricted.

The first sealing film comprises magnesium hydroxide in the range of 0.05 to 0.15 parts by weight, based on 100 parts by weight of the ethylene-vinyl acetate copolymer included in the first sealing film. Accordingly, the first sealing film to be provided on the light-receipt side maintains excellent transparency, with restricting rust generation in the solar battery. As a result, the power generation performance of the solar battery can be further improved.

The second sealing film comprises magnesium hydroxide usually 0.01 parts by weight or more, preferably in the range of 0.1 to 0.5 parts by weight, more preferably more than 0.1 part by weight and 0.5 parts by weight or less, and further preferably more than 0.2 parts by weight and 0.5 parts by weight or less, based on 100 parts by weight of the ethylene-vinyl acetate copolymer included in the second sealing film. Accordingly, rust generation in the solar battery is highly restricted.

The acid acceptor used in the first and the second sealing films of invention has an excellent function for absorbing and/or neutralizing acids such as acetic acid. For this purpose, magnesium hydroxide (Mg(OH)₂) are used.

It is possible that the magnesium hydroxide has a mean particle diameter in the range of 0.01 to 10 µm. The mean particle diameter of magnesium hydroxide is preferably in the range of 1 to 5 µm, particularly in the range of 2 to 3 µm, since the magnesium hydroxide is difficult to scatter light and the sealing film comprising magnesium hydroxide maintains high transparency and provides an enhanced acid receiving performance.

In the pair of sealing films, it is preferable that the second sealing film further comprises a coloring agent. In this case, light reflection occurs at an interface between the first sealing film and the second sealing film, and diffused light reflection occurs due to the presence of the coloring agent. Namely, an incident light irradiated to parts between the solar cells or transmitted through the cells is subjected to a diffused light reflection, and the diffused light is irradiated to the cells again as incident light. Accordingly, the efficiency for using light irradiated to the solar battery and power generation capability are improved.

As the coloring agent, white coloring agents based on titanium oxide, calcium carbonate, zinc oxide, white lead, lithopone, barite, precipitated barium sulfate and calcium sulphate; blue coloring agents based on ultramarine; black pigments based on carbon black; and translucent pigments such as glass beads and a light scattering agent are used. Among the above-discussed coloring agents, white coloring agents are preferably used.

The coloring agent is preferably in the range of 2 to 10 parts by weight, more preferably in the range of 3 to 6 parts by weight, based on 100 parts by weight of the ethylene-vinyl acetate copolymer in the second sealing film.

The mean particle diameter of the coloring agent is preferably in the range of 0.01 to 10 µm, and particularly in the range of 0.1 to 5 µm. By the particle diameter, efficiency for using light is improved.

The mean particle diameters of the acid acceptor and coloring agent are obtained as follows: A cross section of the sealing film is observed by a transmission electron microscope with a magnitude of about 1,000,000. Equivalent circle diameters of projected area, with respect to at least 100 particles of the acid acceptor or the coloring agent, are obtained. Then, the average value of the particle diameters is obtained, as the mean particle diameter.

In the pair of sealing films the second sealing film comprises a lubricant. By use of the lubricant, the adhesion property of the sealing film is further enhanced, and it is made possible to prevent water content from penetrating the solar battery.

As the lubricant, phosphite compound is preferably used. Examples of the phosphite compound include alkyl phosphite such as decyl phosphite; alkyl and aryl acid phosphites such as decyl acid phosphite and phenyl acid phosphite; trialkyl phosphite and triaryl phosphite such as trihexyl phosphate and tricresyl phosphate and zinc dithiophosphate.

The lubricant is contained preferably in the range of 0.01 to 5.0 parts by weight, and particularly in the range of 0.1 to 0.4 parts by weight, based on 100 parts by weight of the ethylene-vinyl acetate copolymer contained in the sealing film.

Each of the first and the second sealing film of the invention includes ethylene-vinyl acetate copolymer. The vinyl acetate content of ethylene-vinyl acetate copolymer is preferably in the range of 20 to 35 parts by weight, more preferably in the range of 22 to 30 parts by weight, particularly preferably in the range of 24 to 28 parts by weight, based on 100 parts by weight of the ethylene-vinyl acetate copolymer. When the vinyl acetate content is less than 20 parts by weight, it is possible that the transparency of the sealing film, which has been obtained after being crosslinked/cured at a high temperature, will become insufficient. When the vinyl acetate content exceeds 35 pars by weight, carboxylic acid, alcohol, amine or the like would be readily produced.

The pair of sealing film comprises ethylene-vinyl acetate copolymer and magnesium hydroxide, as mentioned above. It is preferable that the first and the second sealing films further comprise a crosslinking agent. Accordingly, it is possible to crosslink and cure the ethylene-vinyl acetate copolymer, and to improve the durability of the film.

It is preferable to use an organic peroxide as a crosslinking agent. The organic peroxide is preferably used for obtaining a sealing film having improved adhesion property, transparency, moisture-resistance and temperature dependency of penetration property is obtained.

It is possible to use any organic peroxide as long as the organic peroxide decomposes at a temperature of 100°C or more to generate radicals. Generally speaking, an organic peroxide to be used is selected, with the film forming temperature, conditions for formulating the composition, curing temperature, heat resistance of the application target material/member, and storage stability thereof taking into account. In particular, it is preferable to use a material having a decomposition temperature of 70°C or more in a 10-hour half-life period.

As the above-discussed organic peroxide, 2,5-dimethylhexane-2,5-dihydroperoxide, 2,5-dimethyl-2,5-di(tert-butylperoxy)hexane, 3-di-tert-butylperoxide, tert-dicumylperoxide, 2,5-dimethyl-2,5-di(2-ethylhexanoylperoxy)hexane, 2,5-dimethyl-2,5-di(tert-butylperoxy)hexane, 2,5-dimethyl-2,5-di(tert-butylperoxy)hexine, dicumylperoxide, tert-butylcumylperoxide, α,α'-bis(tert-butyloxyisopropyl)benzene, α,α'-bistert-butylperoxy)diisopropylbenzene, n-butyl-4,4-bis(tert-butylperoxy)butane, 2,2-bis(tert-butylperoxy)butane, 1,1-bis(tert-butylperoxy)cyclohexane, 1,1-bis(tert-butylperoxy)3,3,5-trimethylcyclohexane, tert-butylperoxybenzoate, and benzoylperoxide are preferably used, from the view point of process temperature and storage stability of the resin.

The content of the organic peroxide in each of the first and the second sealing films is preferably in the range of 0.1 to 5 parts by weight, more preferably in the range of 0.5 to 2.0 parts by weight, based on 100 parts by weight of the ethylene-vinyl acetate copolymer. When the content of the organic peroxide is smaller than in the above range, it is possible that the transparency of the sealing film is decreased. On the other hand, when the content of the organic peroxide is greater than in the above range, it is possible that miscibility of the crosslinking agent with respect to the copolymer is decreased.

The first and the second sealing films may further comprise a crosslinking auxiliary agent. The crosslinking auxiliary agent increases the gel fraction of ethylene-vinyl acetate copolymer and durability of the sealing film.

Examples of the above-mentioned crosslinking auxiliary agent (a compound having a free radical polymerization group) include tri-functional crosslinking auxiliary agents such as triallyl cyanurate and triallyl isocyanurate; and mono- or di-functional crosslinking auxiliary agents such as (meth)acrylic esters (e.g., NK esters). Among these compounds, triallyl cyanurate and triallyl isocyanurate are preferably used, and triallyl isocyanurate is particularly preferably used.

The content of the crosslinking auxiliary agent in each of the first and the second sealing films is preferably in the range of 0.1 to 3.0 parts by weight, and in particular in the range of 0.1 to 2.5 parts by weight, based on 100 parts by weight of the ethylene-vinyl acetate copolymer.

It is preferable that the pair of sealing films have excellent adhesion properties, with the sealing properties in the solar battery taking into account. Therefore, the first and the second sealing films preferably further comprise an adhesion promoter.

As the adhesion promoter, a silane coupling agent can be used. By using the silane coupling agent, a sealing film having an excellent adhesion property can be obtained. Examples of the silane coupling agent include γ-chloropropylmethoxysilane, vinylethoxysilane, vinyltris(β-methoxyethoxy)silane, γ-methacryloxypropyltrimethoxysilane, vinyltriacetoxysilane, γ-glycidoxypropyltrimethoxysilane, γ-glycidoxypropyltriethoxysilane, β-(3,4-epoxycyclohexyl)ethyltrimethoxysilane, vinyltrichlorosilane, γ-mercaptopropyltrimethoxysilane, γ-aminopropyltriethoxysilane, and N-β-(aminoethyl)-γ-aminopropyltrimethoxysilane. These silane coupling agents can be used alone or as a combination of two or more. Among the above materials, γ-methacryloxypropyltrimethoxysilane is particularly preferable.

The content of the silane coupling agent in each of the first and the second sealing films is preferably in the range of 0.1 to 0.7 parts by weight, and particularly preferably in the range of 0.15 to 0.65 parts by weight, based on 100 parts by weight of the ethylene-vinyl acetate copolymer.

The pair of sealing films may further include various additives, if necessary, such as a plasticizer, acryloxy-group containing compound, methacryloxy-group containing compound and/or epoxy-group containing compound, for improving or adjusting various properties of the film (mechanical strength, optical properties such as transparency, heat resistance, light resistance, and crosslinking rate, etc).

Generally speaking, polybasic acid esters and polyhydric alcohol esters are used as the above mentioned plasticizer, although there is no special restrictions to the plasticizer to be used. Examples of the plasticizer include dioctyl phthalate, dihexyladipate, triethylene glycol-di-2-ethylbutylate, butyl sebacate, tetraethylene glycol heptanoate and triethylene glycol dipelargonate. The plasticizer can be used singly, or in combination of two or more kinds. The plasticizer is used preferably in an amount of not more than 5 parts by weight, based on 100 parts by weight of the ethylene-vinyl acetate copolymer, in each of the first and the second sealing films.

Generally speaking, acrylic acid or methacrylic acid derivatives, for instance, esters or amides of acrylic acid or methacrylic acid are used as the above-mentioned acryloxy-group containing compound and the methacryloxy-group containing compound. Examples of the ester residue are straight-chain alkyl groups such as methyl, ethyl, dodecyl, stearyl, and lauryl, and cyclohexyl group, tetrahydrofurfuryl group, amino ethyl group, 2-hydroxyethyl group, 3-hydroxypropyl group, and 3-chloro-2-hydroxypropyl group. Examples of the amide are diacetone acrylamide. Further, it is possible to use esters obtained from a polyhydric alcohol such as ethylene glycol, triethylene glycol, polypropylene glycol, polyethylene glycol, triemthylol propane or pentaerythritol, and acrylic acid or methacrylic acid.

As the afore-mentioned epoxy-group-containing compound, triglycidyl tris(2-hydroxyethyl)isocyanurate, neopentylglycol diglycidyl ether, 1,6-hexanediol diglycidyl ether, allyl glycidyl ether, 2-ethylhexyl glycidyl ether, phenyl glycidyl ether, phenol(ethyleneoxy)glycidyl ether, p-tert-butylphenyl glycidyl ether, diglycidyl adipate, diglycidyl phthalate, glycidyl methacrylate or butyl glycidyl ether can be used.

The acryloxy group-containing compound, methacryloxy group-containing compound or epoxy group-containing compound is preferably contained in each of the first and the second sealing films in an amount of 0.5 to 5.0 parts by weight, and preferably 1.0 to 4.0 parts by weight, based on 100 parts by weight of the ethylene-vinyl acetate copolymer.

The pair of sealing films may further comprise an ultraviolet absorber, a light stabilizer, and an anti-aging agent.

By adding the ultraviolet absorber to the pair of sealing films, it is possible to prevent ethylene-vinyl acetate copolymer from being deteriorated as the effect of light irradiation or the like, and the sealing films from yellowing. There is no particular restriction to the ultraviolet absorber to be used in the present invention. Preferable examples of the ultraviolet absorber are benzophenone-based ultraviolet absorbers such as 2-hydroxy-4-methoxybenzophenone, 2-hydroxy-4-n-dodecyloxybenzophenone, 2,4-dihydroxybenzophenone, 2,2'-dihydroxy-4-methoxybenzophenone, and 2-hydroxy-4-n-octoxybanzophenone. Moreover, the content of the benzophenone-based ultraviolet absorber in each of the first and the second sealing films is preferably in the range of 0.01 to 5 parts by weight, based on 100 parts by weight of the ethylene-vinyl acetate copolymer.

It is possible, also by adding the photostabilizer to the pair of sealing films, to prevent ethylene-vinyl acetate copolymer from being deteriorated as the effect of light irradiation or the like, and the sealing films from yellowing. A hindered amine photostabilizer can be used as the photostabilizer. Examples of the photostabilizer include LA-52, LA-57, LA-62, LA-63, LA-63p, LA-67 and LA-68 (each manufactured by ADEKA Co., Ltd.), Tinuvin 744, Tinuvin 770, Tinuvin 765, Tinuvin 144, Tinuvin 622LD, and CHIMASSORB 944LD (each manufactured by Ciba Specialty Chemicals Co., Ltd.), and UV-3034 (each manufactured by B. F. Goodrich). Each of the photostabilizers can be used alone, or in combination of two or more kinds. The amount of the light stabilizer to be blended to each of the first and the second sealing films is preferably in the range of 0.01 to 5 parts by weight based on 100 parts by weight of the ethylene-vinyl acetate copolymer.

Examples of the anti-aging agent are hindered phenol antioxidants such as N,N'-hexan-1,6-diyl-bis[3-(3,5-di-tert-butyl-4-hydroxyphenyl) propionamide], phosphorus-type heat stabilizers, lactone-type heat stabilizers, vitamin E-type heat stabilizers and sulfur-type heat stabilizers.

In the pair of sealing films, the thickness of the first sealing film is preferably greater than that of the second sealing film. In this configuration, stress applied to a solar battery including the sealing films is absorbed by the sealing film(s). Further, it is possible to prevent the first sealing film and the light-receipt side protection member from being peeled from one another at the interface therebetween, and also prevents water from penetrating the solar battery. Namely, rust generation is greatly restricted.

The first sealing film preferably has a thickness in the range of 0.4 mm to 1.4 mm, and particularly in the range of 0. 6 mm to 1.2 mm.

The second sealing film preferably has a thickness in the range of 0.2 mm to 1.0 mm, and particularly in the range of 0.4 mm to 0.8 mm.

It is possible that the sealing films are prepared in accordance with a conventional method. For instance, the composition including the above-discussed materials is molded into a sheet-shaped article by extrusion molding, or calendar molding (calendaring). When a film is formed, e.g. in accordance with extrusion molding by application of heat and pressure by use of rollers, the heat application temperature is generally in the range of 50 to 90°C.

When the second sealing film containing a coloring agent is prepared, the coloring agent can be highly dispersed. It is preferable to prepare a master batch, in advance, by mixing a coloring agent having a high concentration with ethylene-vinyl acetate copolymer, and to prepare a composition by further adding the above-mentioned other components to the master batch.

Moreover, the above-mentioned composition is dissolved to a solvent, and the solution is applied to a proper substrate by using an appropriate coater, and dried to form a coated layer. Thus, a sheet-shaped article can be obtained.

The pair of sealing films is used for sealing a seal target member by providing the seal target member such as solar cells between the first sealing film and the second sealing film. Electrical power is generated by the solar cells upon the receipt of light. In generally used solar batteries, a plurality of solar cells are connected with each other in parallel or in series. The solar cells are provided between the first and the second sealing films and sealed by the films.

In addition to the use in the solar battery, the pair of sealing films is preferably used also for sealing a metal film in a laminated glass for heat ray shield, wherein the metal film is interposed between two transparent substrates. By use of the pair of sealing films of the present invention, rust generation on the metal film is highly restricted. Further, the pair of sealing films of the invention can be preferably used for sealing a metal member by providing the same between the films within products such as a watch, calculator, computer, and mobile phone. The pair of sealing films of the invention is used particularly preferably in solar batteries.

The structure of the solar battery comprising the pair of sealing films is not particularly restricted. As an embodiment shown in Fig. 1, the solar battery includes a back side protection member 12, a second sealing film (back side sealing film) 13B, solar cell(s) 14, first sealing film (light-receipt side sealing film) 13A, and light-receipt side transparent protection member 11, successively in this order. In other words, the solar battery includes in the structure the first sealing film 13A which covers the light-receipt side transparent protection member 11 and the second sealing film 13B which covers the back side protection member 12. Moreover, the solar cells 14 are provided between the first and the second sealing films so that the solar cells contact the fist sealing film 13A and the second sealing film 13B.

The solar cells 14 can be sealed with the sealing films 13A and 13B by interposing the sells therebetween, and crosslinking/curing ethylene-vinyl acetate copolymer included in the first sealing film 13A and the second sealing film 13B. The solar cells 14 can be manufactured not only from silicon monocrystalline or polycrystalline substrate such as silicon power generation element, but also from thin film material such as amorphous silicon, CIGS, CdTe or the like.

For adequately sealing the solar cells 14 in the solar battery, the light-receipt side transparent protection member 11, first sealing film 13A, solar cells 14, second sealing film 13B and back side protection member 12 are successively overlaid in this order. The thus obtained laminate is treated by a conventional method such as application of heat and pressure. The first and the second sealing films are crosslinked and cured.

The thus obtained laminate is subjected to heat and pressure application at a temperature of 135 to 180°C, more preferably 140 to 180°C, in particular 155 to 180°C, by using a vacuum laminator with a degassing time of 0.1 to 5 minutes, with a pressure of 0.1 to 1.5 kg/cm², and a press time of 5 to 15 minutes.

The light-receipt side transparent protection member of the solar battery of the invention is usually a glass substrate such as silicate glass. The thickness of the glass substrate is generally in the range of 0.1 to 10 mm, preferably 0. 3 to 5 mm. The glass plate can be thermally or chemically tempered.

The back side protection member for use in the present invention is a plastic film such as PET. With heat resistance and moisture resistance taking into account, a laminate film including fluorinated polyethylene film, in particular fluorinated polyethylene film, Al film, and fluorinated polyethylene film in this order is preferable.

In the solar battery of the present invention, there is no particular restriction on the members except for the sealing films, e.g., light-receipt side transparent protection member, back side protection member and solar cells. In other words, the members except for the sealing films can have the same structure as that of a conventional solar battery.

### Examples

The present invention will now be explained by referring to Examples. The present invention is not restricted to the examples below.

### [Example 1]

### 1. Preparation of First Sealing Film

Materials with formulation 1 below were supplied to a roll mill, and kneaded at 70°C. The obtained composition was formed by calendaring at 70°C. After the formed composition was allowed to cool, a first sealing film (thickness: 1.0 mm) was obtained.

### Formulation 1:

| | |
|---|---|
| EVA (vinyl acetate content of 26 parts by weight based on 100 parts by weight of EVA) | 100 parts by weight |
| Acid acceptor (Mg(OH)₂, mean particle diameter 3 *µ* m) | 0.1 part by weight |
| Crosslinking agent (2,5-dimethyl-2,5-bis(2-ethylhexanoylperoxy)hexane) | 1.0 part by weight |
| Crosslinking auxiliary agent (triallyl isocyanurate) | 2.0 parts by weight |
| Silane coupling agent (γ-methacryloxypropyltrimethoxysilane) | 0.3 parts by weight |

### 2. Preparation of Second Sealing Film

Materials with formulation 2 below were supplied to a roll mill, and kneaded at 70°C. The obtained composition was formed by calendaring at 70°C. After the formed composition was allowed to cool, a second sealing film (thickness: 1.0 mm) was obtained.

### Formulation 2:

| | |
|---|---|
| EVA (vinyl acetate content of 26 parts by weight based on 100 parts by weight of EVA) | 100 parts by weight |
| Acid acceptor (Mg(OH)₂, mean particle diameter 3 *µ* m) | 0.5 parts by weight |
| Coloring agent (titanium oxide, mean particle diameter of 0.1 *µ* m) | 4.2 parts by weight |
| Crosslinking agent (2,5-dimethyl-2,5-bis(2-ethylhexanoylperoxy)hexane) | 1.0 part by weight |
| Crosslinking auxiliary agent (triallyl isocyanurate) | 2.0 parts by weight |
| Silane coupling agent (γ-methacryloxypropyltrimethoxysilane) | 0.15 parts by weight |
| Lubricant (trisisodecyl phosphite) | 0.3 parts by weight |

The determination of the content of Mg(OH)₂ was carried out by using scanning X-ray fluorescence analyzer (ZSX Primus II, Rigaku Industrial Co.).

### 3. Preparation of Solar battery

The first sealing film and the second sealing film prepared as explained above were used. A light-receiving side transparent protection member made of glass plate (thickness: 0.3 mm), the first sealing film, solar cells made of silicone power generation element, the second sealing films, and a back side protection member made of fluorinated polyethylene film (thickness: 50 *µ*m) were successively overlaid in this order. The thus obtained laminate was introduced to a rubber bag and subjected to vacuum degassing and preliminary pressure contact treatment at a temperature of 100°C. Subsequently, the laminate was placed into an oven, and pressure and heat were applied to the laminate for 30 minutes under a pressure of 13 × 10⁵ Pa and a temperature of 140°C.

### [Example 2a (for comparison) and Comparative Examples 1 to 3]

Sealing films were prepared by repeating Example 1 except that the concentrations of the acid acceptor included in the first and the second sealing films were changed as shown in Table 1.

### (Evaluation)

Simulated solar light at a radiation intensity of 1000 m W/cm² was irradiated at 25°C, to the solar batteries prepared as above, by using a solar simulator wherein the spectrum of the light is adjusted to have AM of 1.5. The open-circuit voltage [V] of the solar battery, nominal maximum power current [A] per cm², and nominal maximum power voltage [V] were measured. From the product of these values, nominal maximum power A₁ [W] (JIS C8911 1998) were obtained.

After leaving the solar batteries under an environment in accordance with JIS-C-8917 (2005) (temperature : 85±2°C, humidity: 85±5%RH) for 5500 hours, nominal maximum power A₂ [W] was determined in the same way as discussed above. The difference of the nominal maximum powers between the solar battery before and after leaving the solar batteries in the above-discussed condition, i.e., the rate of change (difference) between the nominal maximum powers [(A₂-A₁)/A₁×100] was obtained. The results are shown in Table 1.

### [Table 1]

**Table 1**

| | Example 1 | Example 2ₐ | Comp. Ex. 1 | Comp. Ex. 2 | Comp. Ex. 3 |
|---|---|---|---|---|---|
| Mg(OH)₂ content in First Sealing Film [parts by weight] | 0.1 | 0 | 0.1 | 0.05 | 0 |
| Mg(OH)₂ content in Second Sealing Film [parts by weight] | 0.5 | 0.5 | 0 | 0 | 0 |
| Difference between nominal maximum powers [%] | -8.59 | -10.12 | -10.41 | -10.62 | -50 or more |

As shown in Table 1, a solar battery which includes a pair of sealing films of the present invention exhibits excellent power generating property for a long time and is excellent in durability.

### Industrial field for Utilization

A pair of sealing films of the invention is preferably used for sealing a metal member provided between the sealing films, which are provided in electronic products such as a solar battery, watch, calculator, computer, and mobile phone, and other products such as a laminated glass for heat ray shield.

## Claims

1. A pair of sealing films for sealing a seal target member configured to be interposed between the sealing films, the seal target member being solar cells, comprising:
a first sealing film comprising ethylene-vinyl acetate copolymer and magnesium hydroxide in an amount of 0.05 to 0.15 parts by weight based on 100 parts by weight of the ethylene-vinyl acetate copolymer; and
a second sealing film comprising ethylene-vinyl acetate copolymer and 0.01 part by weight or more of magnesium hydroxide based on 100 parts by weight of the ethylene-vinyl acetate copolymer, wherein the second sealing film comprises a lubricant.

2. The pair of sealing films as defined in claim 1, wherein the second sealing film comprises magnesium hydroxide in an amount of 0.1 to 0.5 parts by weight, based on 100 parts by weight of the ethylene-vinyl acetate copolymer.

3. The pair of sealing films as defined in claim 1 or 2, wherein the second sealing film comprises a coloring agent.

4. The pair of sealing films as defined in any of claims 1 to 3, wherein the lubricant is a phosphite compound.

5. The pair of sealing films as defined in any of claims 1 to 4, wherein the thickness of the first sealing film is greater than that of the second sealing film.

6. A solar battery comprising:
a light-receipt side transparent protection member;
a first sealing film comprising ethylene-vinyl acetate copolymer which covers the light-receipt side transparent protection member;
a back side protection member;
a second sealing film comprising ethylene-vinyl acetate copolymer which covers the back side protection member; and
solar cells provided between the first and the second sealing films;
the first sealing film provided on the light-receipt side of the solar cells, comprising magnesium hydroxide in an amount of 0.05 to 0.15 parts by weight, based on 100 parts by weight of the ethylene-vinyl acetate copolymer, and the second sealing film provided on the back side of the solar cells,comprising magnesium hydroxide in an amount of 0.01 parts by weight or more, based on 100 parts by weight of the ethylene-vinyl acetate copolymer, wherein the second sealing film comprises a lubricant.

7. The solar battery as defined in claim 6, wherein the second sealing film comprises magnesium hydroxide in an amount of 0.1 to 0.5 parts by weight, based on 100 parts by weight of the ethylene-vinyl acetate copolymer.

8. The solar battery as defined in claim 6 or 7, wherein the second sealing film comprises a coloring agent.

9. The solar battery as defined in any of claims 6 to 8, wherein the lubricant is a phosphite compound.

10. The solar battery as defined in any of claims 6 to 9, wherein the thickness of the first sealing film is greater than that of the second sealing film.

## Patentansprüche

1. Dichtfilmpaar zum dichten Verschließen eines Dichtfilm-Zielgliedes, konfiguriert, um zwischen den Dichtfilmen eingelegt zu werden, wobei das Dicht-Zielglied aus Solarzellen besteht, Folgendes umfassend:
einen ersten Dichtfilm, umfassend Ethylen-Vinylacetat-Copolymer und Magnesiumhydroxid in einer Konzentration von 0,05 bis 0,15 Gewichtsanteilen, basierend auf 100 Gewichtsanteilen des Ethylen-Vinylacetat-Copolymers; und
einen zweiten Dichtfilm, umfassend Ethylen-Vinylacetat-Copolymer und 0,01 Gewichtsanteil Magnesiumhydroxid, basierend auf 100 Gewichtsanteilen des Ethylen-Vinylacetat-Copolymers, wobei der zweite Dichtfilm ein Schmiermittel umfasst.

2. Dichtfilmpaar nach Anspruch 1, bei welchem der zweite Dichtfilm Magnesiumhydroxid in einer Konzentration von 0,1 bis 0,5 Gewichtsanteilen umfasst, basierend auf 100 Gewichtsanteilen Ethylen-Vinylacetat-Copolymer.

3. Dichtfilmpaar nach Anspruch 1 oder 2, bei welchem der zweite Dichtfilm ein Färbemittel umfasst.

4. Dichtfilmpaar nach einem der Ansprüche 1 bis 3, bei welchem das Schmiermittel eine Phosphitverbindung ist.

5. Dichtfilmpaar nach einem der Ansprüche 1 bis 4, bei welchem die Dicke des ersten Dichtfilms größer als diejenige des zweiten Dichtfilms ist.

6. Solarbatterie, Folgendes umfassend:
ein transparentes Schutzglied auf der lichtempfangenden Seite;
einen ersten Dichtfilm, umfassend ein Ethylen-Vinylacetat-Copolymer, welcher das transparente Schutzglied auf der lichtempfangenden Seite bedeckt;
ein Schutzglied auf der Rückseite;
einen zweiten Dichtfilm, umfassend ein Ethylen-Vinylacetat-Copolymer, welcher das Schutzglied auf der Rückseite bedeckt;
Solarzelle, welche zwischen dem ersten und dem zweiten Dichtfilm bereitgestellt sind;
wobei der erste Dichtfilm an der lichtempfangenden Seite der Solarzellen bereitgestellt ist, umfassend Magnesiumhydroxid in einer Konzentration von 0,05 bis 0,15 Gewichtsanteilen, basierend auf 100 Gewichtsanteilen des Ethylen-Vinylacetat-Copolymers, und der zweite Dichtfilm an der Rückseite der Solarzellen bereitgestellt ist, umfassend Magnesiumhydroxid in einer Konzentration von 0,01 Gewichtsanteilen oder darüber, basierend auf 100 Gewichtsanteilen des Ethylen-Vinylacetat-Copolymers, wobei der zweite Dichtfilm ein Schmiermittel umfasst.

7. Solarbatterie nach Anspruch 6, bei welcher der zweite Dichtfilm Magnesiumhydroxid in einer Konzentration von 0,1 bis 0,5 Gewichtsanteilen umfasst, basierend auf 100 Gewichtsanteilen des Ethylen-Vinylacetat-Copolymers.

8. Solarbatterie nach Anspruch 6 oder 7, bei welcher der zweite Dichtfilm ein Färbemittel umfasst.

9. Solarbatterie nach einem der Ansprüche 6 bis 8, bei welcher das Schmiermittel eine Phosphitverbindung ist.

10. Solarbatterie nach einem der Ansprüche 6 bis 9, bei welchem die Dicke des ersten Dichtfilms größer als diejenige des zweiten Dichtfilms ist.

## Revendications

1. Paire de films d'étanchéité destinée à rendre étanche un élément cible d'étanchéité configuré pour être intercalé entre les films d'étanchéité, l'élément cible d'étanchéité étant des cellules solaires, comprenant :
un premier film d'étanchéité comprenant un copolymère d'éthylène-acétate de vinyle et de l'hydroxyde de magnésium en une quantité de 0,05 à 0,15 partie en poids sur la base de 100 parties en poids du copolymère d'éthylène-acétate de vinyle ; et
un deuxième film d'étanchéité comprenant un copolymère d'éthylène-acétate de vinyle et 0,01 partie en poids ou plus d'hydroxyde de magnésium sur la base de 100 parties en poids du copolymère d'éthylène-acétate de vinyle, dans laquelle le deuxième film d'étanchéité comprend un lubrifiant.

2. Paire de films d'étanchéité telle que définie dans la revendication 1, dans laquelle le deuxième film d'étanchéité comprend de l'hydroxyde de magnésium en une quantité de 0,1 à 0,5 partie en poids, sur la base de 100 parties en poids du copolymère d'éthylène-acétate de vinyle.

3. Paire de films d'étanchéité telle que définie dans la revendication 1 ou 2, dans laquelle le deuxième film d'étanchéité comprend un agent de coloration.

4. Paire de films d'étanchéité telle que définie dans l'une quelconque des revendications 1 à 3, dans laquelle le lubrifiant est un composé au phosphite.

5. Paire de films d'étanchéité telle que définie dans l'une quelconque des revendications 1 à 4, dans laquelle l'épaisseur du premier film d'étanchéité est supérieure à celle du deuxième film d'étanchéité.

6. Batterie solaire comprenant :
un élément de protection transparent côté réception de la lumière ;
un premier film d'étanchéité comprenant un copolymère d'éthylène-acétate de vinyle qui couvre l'élément de protection transparent côté réception de la lumière ;
un élément de protection côté arrière ;
un deuxième film d'étanchéité comprenant un copolymère d'éthylène-acétate de vinyle qui couvre l'élément de protection côté arrière ; et
des cellules solaires prévues entre le premier et le deuxième film d'étanchéité ;
le premier film d'étanchéité prévu sur le côté réception de la lumière des cellules solaires, comprenant de l'hydroxyde de magnésium en une quantité de 0,05 à 0,15 partie en poids, sur la base de 100 parties en poids du copolymère d'éthylène-acétate de vinyle, et le deuxième film d'étanchéité prévu sur le côté arrière des cellules solaires, comprenant de l'hydroxyde de magnésium en une quantité de 0,01 partie en poids ou plus, sur la base de 100 parties en poids du copolymère d'éthylène-acétate de vinyle, dans laquelle le deuxième film d'étanchéité comprend un lubrifiant.

7. Batterie solaire telle que définie dans la revendication 6, dans laquelle le deuxième film d'étanchéité comprend de l'hydroxyde de magnésium en une quantité de 0,1 à 0,5 partie en poids, sur la base de 100 parties en poids du copolymère d'éthylène-acétate de vinyle.

8. Batterie solaire telle que définie dans la revendication 6 ou 7, dans laquelle le deuxième film d'étanchéité comprend un agent de coloration.

9. Batterie solaire telle que définie dans l'une quelconque des revendications 6 à 8, dans laquelle le lubrifiant est un composé au phosphite.

10. Batterie solaire telle que définie dans l'une quelconque des revendications 6 à 9, dans laquelle l'épaisseur du premier film d'étanchéité est supérieure à celle du deuxième film d'étanchéité.
